# EUROPEAN PATENT SPECIFICATION

(11) **EP 3 315 980 B1**
(45) Date of publication and mention of the grant of the patent: **15.05.2024**
(21) Application number: 16814236.2
(22) Date of filing: 15.06.2016
(51) Int. Cl.: G01R 31/333, G01R 31/327

(54) **TESTING METHOD FOR A DC CIRCUIT BREAKER**
PRÜFVERFAHREN FÜR EINEN GLEICHSTROMSCHUTZSCHALTER
PROCÉDÉ D'ESSAI DESTINÉ À UN DISJONCTEUR À COURANT CONTINU (CC)

(30) Priority: 26.06.2015 JP 2015128419
(43) Date of publication of application: 02.05.2018
(73) Proprietor: Kabushiki Kaisha Toshiba, Minato-ku Tokyo 105-8001 (JP)
(72) Inventor: HASHIMOTO, Yuhei, Tokyo 105-8001 (JP); MIYAZAKI, Kensaku, Tokyo 105-8001 (JP); TANEDA, Takahiro, Tokyo 105-8001 (JP); OPPATA, Shogo, Tokyo 105-8001 (JP); KUDO, Kietsu, Tokyo 105-8001 (JP); KOYAMA, Hiroshi, Tokyo 105-8001 (JP)
(74) Representative: AWA Sweden AB
(86) International application number: PCT/JP2016/067736
(87) International publication number: WO 2016/208465

(56) References cited:
- WO-A1-2015/037223
- WO-A1-2017/071413
- JP-A- S5 049 667
- JP-A- S5 280 476
- JP-A- S5 757 267
- JP-A- 2003 115 242
- JP-A- 2015 056 389
- JP-A- 2015 059 891
- US-A- 3 942 103
- BAOLIANG SHENG ED - HEDIO TATIZAWA ET AL: "A synthetic test circuit for current switching tests of HVDC circuit breakers", TRANSMISSION AND DISTRIBUTION CONFERENCE AND EXPOSITION, 2008. T&D. IEEE/PES, IEEE, PISCATAWAY, NJ, USA, 21 April 2008 (2008-04-21), pages 1-4, XP031250195, ISBN: 978-1-4244-1903-6

## Description

### FIELD

Embodiments of the present disclosure relate to a testing method for verifying the current breaking performance of a DC circuit breaker.

### BACKGROUND

Large-capacity AC circuit breakers are applied to protect a system from a short-circuit accident due to lightning strike, etc., to an AC power system. A testing method called a synthetic testing method is known as a current breaking testing method for such AC circuit breakers (see, for example, Non-Patent Document 1). This synthetic testing method is performed using a testing device including a current source circuit for supplying a short-circuit current equivalent to a fault current to an AC circuit breaker subjected to a test, and a voltage source circuit that supplies a high-frequency current to apply a recovery voltage to an AC circuit breaker subjected to a test, in which both circuits are connected in parallel with each other.

More specifically, the current breaking test of an AC circuit breaker is performed through the following procedures (1) to (4).
(1) An AC short-circuit current equivalent to a fault current is supplied from a current source circuit to the AC circuit breaker.
(2) A high-frequency current is supplied from the voltage source circuit immediately before the final zero value of the short-circuit current, and a superimposed current from two circuits that are the current source circuit and the voltage source circuit is flown to the AC circuit breaker.
(3) The current source circuit is broken from the AC circuit breaker when the short-circuit current reaches the final zero value.
(4) Subsequently, the high-frequency current is broken by the AC circuit breaker, and a recovery voltage is generated between the terminals of the AC circuit breaker.

Meanwhile, DC circuit breakers are applied to protect a system from the short-circuit accident of a DC system. The DC circuit breaker breaks a fault current due to short circuit, etc. In order to secure such a system protection, the DC circuit breaker needs to have a predetermined current breaking performance in accordance with the DC system.

As the testing method for current breaking by a DC circuit breaker, there is a method of rectifying a short-circuit fault current from an AC short-circuit generator into a DC current by a rectifier, and supplying a fault current at the time of the short-circuit simulating a DC system fault.JP 2003 115242 A relates to a circuit-breaker test circuit for verifying interruption capability of a DC circuit breaker. WO 2015/037223 A1 relates to a device and a test method for testing a DC circuit breaker.

### CITATION LIST

### PATENT LITERATURES

Non-Patent Document 1: The Institute of Electrical Engineers of Japan, Japanese Electrotechnical Committee, AC circuit breaker, JEC-2300-1998

### SUMMARY

However, in recent years, the capacity of DC circuit breakers is increasing. Hence, in the conventional testing method using a rectifier, it is necessary to provide a large-capacity rectifier, and there are disadvantages of an increase in a size of the testing equipment and an enormous investment for installation of the testing equipment. In addition, the testing method using a large-capacity rectifier has a disadvantage in testing efficiency. Hence, it is difficult to adopt the conventional testing method using a rectifier, and other testing method is required.

In this regard, a testing device applied for the synthetic testing method for an AC circuit breaker may be applied for the current breaking performance test of a DC circuit breaker. In this case, however, the current breaking performance test cannot be performed through the above schemes. That is, according to the above synthetic testing method, the current and the voltage equivalent to the accident of a DC system cannot be applied together to the DC circuit breaker, and the current breaking performance of the DC circuit breaker cannot be verified.

A testing method for a DC circuit breaker according to an embodiment of the present disclosure has been made to address the foregoing disadvantages, and an objective is to provide testing a method for a DC circuit breaker verifying the current breaking performance of the DC circuit breaker.

The invention is defined by the appended claims.

### BRIEF DESCRIPTION OF DRAWINGS

FIG. 1 is a circuit diagram illustrating a structure of a testing device for a DC circuit breaker according to a first embodiment;
FIG. 2 is a current waveform diagram in the process of a short-circuit current breaking according to a first testing method of the invention;
FIG. 3 is a voltage waveform diagram in the process of the short-circuit current breaking according to the first testing method;
FIG. 4 is a circuit diagram illustrating a structure of a testing device for a DC circuit breaker applied in a second unclaimed testing method;
FIG. 5 is a current waveform diagram in the process of a short-circuit current breaking according to the second testing method; and
FIG. 6 is a voltage waveform diagram in the process of the short-circuit current breaking according to the second testing method.

### DETAILED DESCRIPTION

### [1. First Embodiment]

### [1-1. Entire Structure]

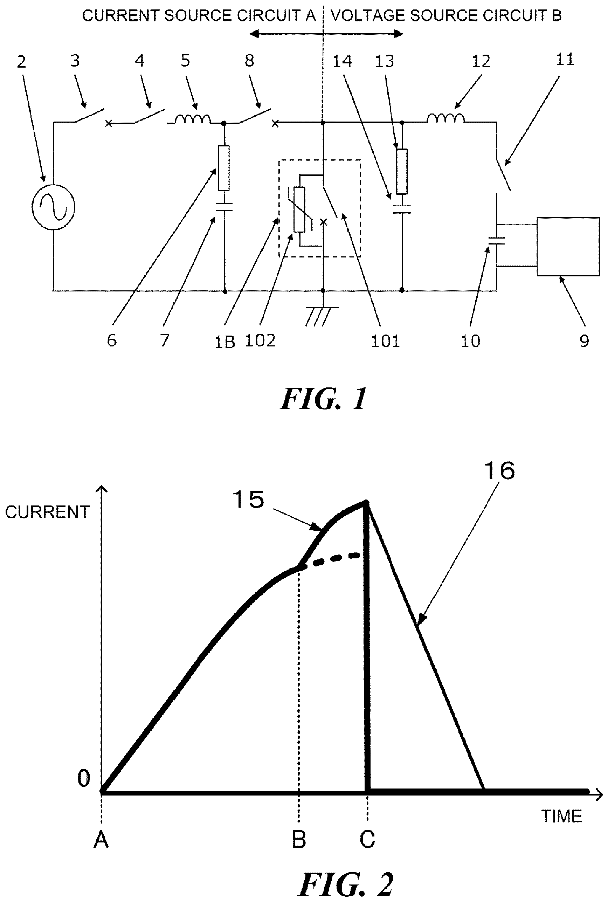

A testing method for a DC circuit breaker according to this embodiment, and a test device applied for the testing method will be described below with reference to FIGs. 1 to 3. FIG. 1 is a circuit diagram illustrating a structure of a testing device for a DC circuit breaker according to this embodiment.

The testing device for a DC circuit breaker is a device that tests the DC current breaking performance of a DC circuit breaker 1 to be tested. The testing device for the DC circuit breaker according to this embodiment employs a structure similar to that of a synthetic testing circuit applied in conventional current breaking test for an AC circuit breaker. That is, according to this embodiment, the synthetic testing circuit is used with the AC circuit breaker installed in the synthetic testing circuit replaced by a DC circuit breaker, and the current breaking performance of the DC circuit breaker is verified. More specifically, this testing device includes two power supply circuits to be described later in order to simulate the occurrence of an accident in the DC system. Example DC systems are a DC power transmission system such as a long-distance power transmission and systems between electric power companies, DC power distribution in buildings and large-scale commercial facilities, etc., and DC systems for electric railroads, etc.

The DC circuit breaker 1 is a circuit breaker which breaks a DC current flowing in the DC circuit breaker 1. The DC circuit breaker 1 includes a breaker unit 101 and an energy absorbing unit 102. The breaker unit 101 and the energy absorbing unit 102 are provided in parallel with each other.

The breaker unit 101 is a switch that breaks and makes the current flowing through the circuit. The breaker unit 101 includes, for example, a semiconductor circuit breaker employing a semiconductor. In addition to the semiconductor breaker unit, the breaker unit 101 may include a mechanical breaker unit that mechanically breaks and makes the current.

The energy absorbing unit 102 is a so-called surge absorber (hereinafter, also referred to as a surge absorber 102). The surge absorber 102 absorbs transient high-voltage energy applied to the surge absorber 102. The surge absorber 102 limits the magnitude of the voltage after the current breaking by the breaker unit 101.

To the DC circuit breaker 1, two different power supply circuits are connected in parallel with each other. That is, the testing device according to this embodiment includes a current source circuit A that supplies an AC current to the DC circuit breaker 1, and a voltage source circuit B that applies a recovery voltage to the DC circuit breaker 1, and these circuits A and B are connected in parallel relative to the DC circuit breaker 1.

### [1-2. Detailed Structure]

### (Current Source Circuit)

The current source circuit A supplies an AC current to the DC circuit breaker 1. The current source circuit A includes a short-circuit generator 2, a protection circuit breaker 3, a closing switch 4, a reactor 5, a resistor 6, a capacitor 7, and an auxiliary circuit breaker 8.

The short-circuit generator 2 is a generator that generates a short-circuit current. The short-circuit current generated from the short-circuit generator 2 is an AC current. The short-circuit current generated by the short-circuit generator 2 is output to the DC circuit breaker 1 via the reactor 5.

Provided between the short-circuit generator 2 and the DC circuit breaker 1 are the protection circuit breaker 3 and the closing switch 4. The closing switch 4 is a switch for connecting the short-circuit generator 2 to the testing circuit, and switches a connection and a break of the short-circuit generator 2 relative to the DC circuit breaker 1. The protection circuit breaker 3 is a circuit breaker that breaks the AC short-circuit current flowing through the current source circuit A. The protection circuit breaker 3 breaks the AC short-circuit current at the current zero point of this current.

Further, provided in the current source circuit A are the auxiliary circuit breaker 8 and a surge absorbing unit are provided. The auxiliary circuit breaker 8 is connected to the short-circuit generator 2, and switches a connection and a break of the DC circuit breaker 1 to be tested with the short-circuit generator 2. The auxiliary circuit breaker 8 is, for example, a mechanical circuit breaker. In the current source circuit A, the auxiliary circuit breaker 8 is provided at the DC circuit breaker 1-side among the components. When the auxiliary circuit breaker 8 is in the closed state, the current can be supplied from the short-circuit generator 2 to the DC circuit breaker 1, and when the auxiliary circuit breaker 8 is in the opened state, the current source circuit A is disconnected from the DC circuit breaker 1, and current is not supplied from the short-circuit generator 2 to the DC circuit breaker 1.

The surge absorbing unit is connected to the auxiliary circuit breaker 8, and absorbs a surge generated when broken by the auxiliary circuit breaker 8. In the surge absorbing unit, the resistor 6 and the capacitor 7 are connected in series, and the capacitor 7 absorbs the surge via the resistor 6, facilitating the auxiliary circuit breaker 8 to break.

### (Voltage Source Circuit)

The voltage source circuit B applies a recovery voltage to the DC circuit breaker 1. The voltage source circuit B includes a voltage source capacitor 10, a charging device 9, a starting switch 11, a reactor 12, a resistor 13, and a capacitor 14.

The voltage source capacitor 10 is a DC capacitor serving as a voltage source for the voltage source circuit B. The voltage source capacitor 10 applies the recovery voltage to the DC circuit breaker 1 via the reactor 12 when the starting switch 11 is in the closed state. The voltage source capacitor 10 has a capacity for supplying a part of the short-circuit current at the time of a DC system accident of the DC system of the DC circuit breaker 1. In addition, as for the recovery voltage, other capacitors may be applied to adjust the transient recovery voltage.

The charging device 9 is a device connected in parallel with the voltage source capacitor 10, and charges the voltage source capacitor 10. The starting switch 11 is a device for switching ON and OFF of the voltage application from the voltage source capacitor 10.

The voltage source circuit B includes a transient oscillation circuit (an LCR circuit) with the voltage source capacitor 10 as a DC voltage source. That is, the reactor 12, the resistor 13, and the capacitor 14 are connected in series relative to the voltage source capacitor 10 to construct a transient oscillation circuit. This transient oscillation circuit causes a transient phenomenon, to adjust the voltage to be applied to the DC circuit breaker 1. Hence, the recovery voltage applied by the voltage source circuit B to the DC circuit breaker 1 is a high-frequency voltage.

The capacitor 14 is a voltage adjusting capacitor that adjusts the voltage supplied by the voltage source capacitor 10. In this case, the capacitor 14 is provided together with the voltage source capacitor 10 to adjust the voltage applied to the DC circuit breaker 1 at the time of the DC system accident.

### [1-3. Testing Method]

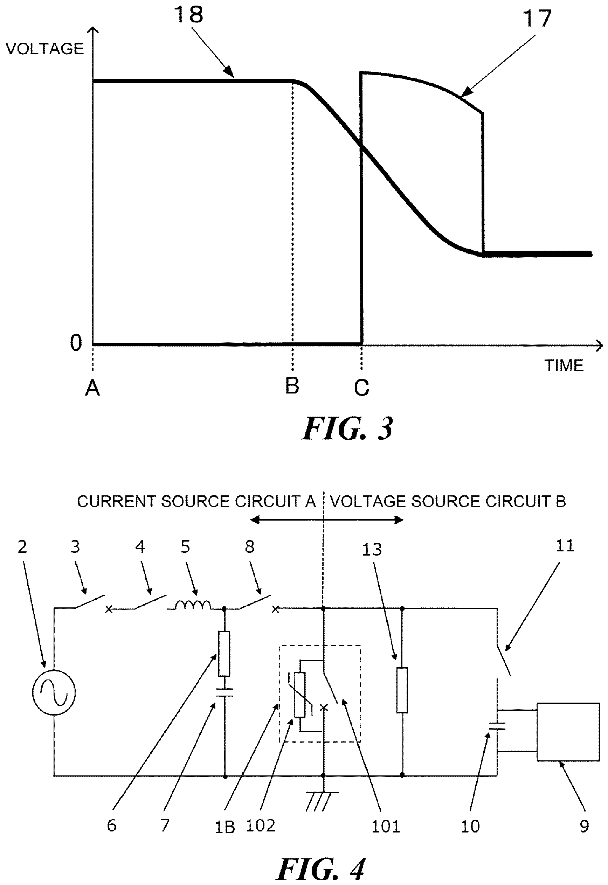

The testing method in this embodiment is a method of verifying the current breaking performance of a DC circuit breaker including a semiconductor circuit breaker for a short-circuit fault current in a DC system, and (1) a first testing method for verifying the current breaking performance at the instant time of current breaking, and (2) a second testing method for verifying the current breaking performance after the current breaking are carried out separately. The testing method for the current breaking performance at the instant time of current breaking will be described with reference to FIGs. 2 and 3. FIG. 2 is a current waveform diagram in the process of the short-circuit current breaking in the first testing method. FIG. 3 is a voltage waveform diagram in the process of the short-circuit current breaking in the first testing method.

### (1) First Testing Method for Verifying Current Breaking Performance at Instant Time of Current Breaking

At the start of the test, the DC circuit breaker 1 is connected to the testing device with the protection circuit breaker 3 and the auxiliary circuit breaker 8 in the closed state, the closing switch 4 and the starting switch 11 in the opened state, the short-circuit generator 2 in an excited state in a predetermined voltage beforehand, and the voltage source capacitor 10 charged to a predetermined voltage by the charging device 9 beforehand.

First, as illustrated in FIG. 3, the closing switch 4 is closed at a time A, and an AC current is supplied from the short-circuit generator 2 to the breaker unit 101 of the DC circuit breaker 1. This AC current is 0 A at the time A, and then increases. The magnitude of this AC current is adjusted by the reactor 5.

Next, at a time B, the starting switch 11 is closed. This closing timing is before the AC current supplied by the short-circuit generator 2 reaches the peak value. That is, it may be up to 1/4 cycle of the AC current. In this embodiment, the current supplied to the breaker unit 101 until the starting switch 11 is closed is less than the fault current due to the system accident in the DC system.

The closing timing of the starting switch 11 may be before the breaker unit 101 of the DC circuit breaker 1 breaks the current, and includes at the same time as the current breaking or a time right before the current breaking. In this embodiment, the closing timing of the starting switch 11 is before the current breaking.

When the starting switch 11 is closed, the AC current having a frequency determined by the voltage source capacitor 10 and the reactor 12 is supplied to the breaker unit 101. That is, when the starting switch 11 is closed, the voltage source circuit B is connected to the DC circuit breaker, and the AC current from the voltage source circuit B is superimposed on the AC current from the short-circuit generator 2. As illustrated in FIG. 2, this superimposed current 15 is supplied to the breaker unit 101 and increases. In addition, because the starting switch 11 is closed at the time B, the voltage source circuit B is connected to the DC circuit breaker 1, and a voltage is applied to the DC circuit breaker 1. Since the main power supply of the voltage source circuit B is the voltage source capacitor 10, as illustrated in FIG. 3, the voltage of the voltage source capacitor 10 decreases due to the discharging.

After the current 15 is superimposed, the current 15 is current chopped by opening the breaker unit 101 and the auxiliary circuit breaker 8 at a time C which the current 15 becomes equal to or more than the fault current, and the current 15 is broken. In this embodiment, the current 15 is broken when reaching the current equivalent to the fault current.

Due to this current breaking, a transient recovery voltage 17 from the voltage source circuit B is applied across the breaker unit 101 of the DC circuit breaker 1, and the surge absorber 102 absorbs the overvoltage, and as illustrated in FIG. 2, the current supplied from the voltage source capacitor 10 becomes a surge absorber current 16 that flows through the surge absorber 102. The voltage of the voltage source capacitor 10 at a time C is equal to or higher than the voltage equivalent to the voltage applied to the DC circuit breaker 1 at the time of current breaking due to the accident in the DC system.

As described above, at the stage of supplying the current less than the fault current to the DC circuit breaker 1, by connecting the voltage source circuit B to the DC circuit breaker 1 prior to the current breaking, both the current supply and the voltage application are performed on the DC circuit breaker 1. Hence, the current equivalent to the fault current due to the accident in the DC system, and the predetermined recovery voltage that is equivalent to the voltage to be applied with the accident are given to the DC circuit breaker 1 at the time of current breaking, and thus the current breaking performance for the DC circuit breaker 1 at the time of current breaking can be verified.

### [Modified Examples of First Testing Method]

(1) In the first testing method as described above, the closing timing of the starting switch 11 is set to be a timing prior to the current breaking by the DC circuit breaker 1, and the voltage source circuit B is connected to the DC circuit breaker 1 prior to the current breaking, but it is appropriate as long as the current equivalent to the fault current and the predetermined recovery voltage equivalent to the voltage with the fault current are applied to the DC circuit breaker 1 at the time of current breaking, and the connection timing of the voltage source circuit B to the DC circuit breaker 1 may be simultaneous with this current breaking. According to this structure, also, it is possible to supply the current equivalent to the fault current and the predetermined recovery voltage equivalent to the voltage with the fault current breaking at the time of current breaking.
(2) In the first testing method as described above, the current equivalent to the fault current to the DC circuit breaker 1 is supplied by superimposing the current source circuit A and voltage source circuit B, but may be supplied by only the current source circuit A. In this case, the connection of the voltage source circuit B to the DC circuit breaker 1 is performed simultaneously with the current breaking.

In the first testing method as described above, the closing timing of the starting switch 11 is simply set to be prior to the current breaking by the DC circuit breaker 1, but like the above embodiment, if the voltage source of the voltage source circuit B is constructed by a capacitor, it is preferable that the closing timing should be set to be immediately before the current breaking by the DC circuit breaker 1. That is, in such structure, as illustrated in FIG. 3, the voltage of the voltage source circuit B decreases by the discharge of the capacitor. Hence, when the starting switch 11 is closed at a stage quite earlier than the current breaking, there is a possibility that the predetermined recovery voltage cannot be applied at the time of current breaking. Therefore, the closing of the starting switch 11, that is, the connection of the DC circuit breaker 1 to the voltage source circuit B is set to be immediately before the current breaking. The term "immediately before the current breaking" in this case means the timing at which the voltage source circuit B is capable of applying, to the DC circuit breaker 1, the predetermined recovery voltage equivalent to the voltage with the breaking of the fault current at the time of current breaking.

### (2) Second Testing Method for Verifying Current breaking performance after Current Breaking

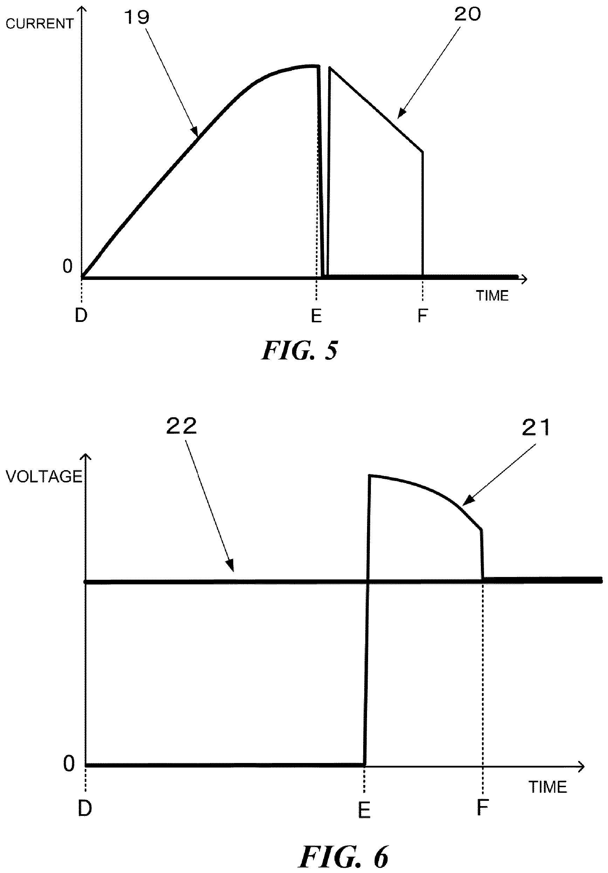

Next, a second testing method, that is, a testing method for verifying the current breaking performance of the DC circuit breaker 1 after the breaking of the current equivalent to the fault current will be described. FIG. 4 is a circuit diagram of a testing device that is the testing device in FIG. 1 without the reactor 12 and the capacitor 14 of the voltage source circuit B. In the second testing method, this testing device is applied. Since the voltage source circuit B does not include the reactor 12 and the capacitor 14, the voltage applied to the DC circuit breaker 1 is a DC voltage. FIG. 5 is a current waveform diagram in the process of breaking the short-circuit current according to the second testing method. FIG. 6 is a voltage waveform diagram in the process of breaking the short-circuit current according to the second testing method.

At the start of the test, the DC circuit breaker 1 is connected to the testing device, with the protection circuit breaker 3 and the auxiliary circuit breaker 8 in the closed state, the closing switch 4 and the starting switch 11 in the opened state, the short-circuit generator 2 in the excited state by the predetermined voltage beforehand, and the voltage source capacitor 10 charged to the predetermined voltage by the charging device 9 beforehand.

First, as illustrated in FIG. 5, the closing switch 4 is closed at a time D, and an AC current is supplied from the short-circuit generator 2 to the breaker unit 101 of the DC circuit breaker 1. This AC current has the magnitude adjusted by the reactor 5, and is supplied to the breaker unit 101 as a fault current 19. Note that as illustrated in FIG. 6, even when the closing switch 4 is closed, since the voltage source circuit B is not connected to the DC circuit breaker 1, a voltage 18 of the voltage source capacitor 10 is kept constant.

Next, at a time E illustrated in FIGs. 5 and 6, the DC circuit breaker 1 breaks a current 19. That is, at the time at which the current 19 reaches the current equivalent to the fault current due to the system accident in the DC system, the breaker block 101 is opened to current chop the current, and the current 19 is broken.

When the current 19 is broken, a recovery voltage 21 with a frequency determined by the reactor 5, the resistor 6, and the capacitor 7 is applied to the DC circuit breaker 1, the surge absorber 102 absorbs the overvoltage, and as illustrated in FIG. 5, the current supplied from the short-circuit generator 2 flows through the surge absorber 102 as a surge absorber current 20. While the surge absorber current 20 is flowing, as illustrated in FIG. 6, the recovery voltage 21 gradually decreases.

After the application of the recovery voltage 21, the connection of the current source circuit A to the DC breaker 1 is maintained. After the application of this recovery voltage 21, at a time F at which the surge absorber current 20 is flowing, the starting switch 11 is closed, and the auxiliary circuit breaker 8 is opened to chop the current. In this case, a DC voltage equivalent to the voltage source capacitor voltage 22 accumulated in the voltage source capacitor 10 is applied to the DC circuit breaker 1.

Accordingly, since the timing at which the voltage is applied to the DC circuit breaker 1 using the voltage source circuit B is delayed until the recovery voltage after the current breaking equivalent to the fault current is applied, the recovery voltage for the DC circuit breaker 1 can be compensated.

More specifically, the application of the DC voltage from the voltage source circuit B is set to be a timing after the current breaking and before the recovery voltage applied to the breaker unit 101 of the DC circuit breaker 1 becomes less than the voltage equivalent to the DC system fault voltage. This enables a verification of the withstand voltage performance of the DC circuit breaker 1 after the breaking of the fault current. As illustrated in FIG. 6, in this embodiment, the recovery voltage 21 keenly decreases at the timing of the time F, this is because all the energy accumulated in the reactor 5 is discharged.

### [1-4. Effects]

(1) The testing method for the DC circuit breaker according to this embodiment is a testing method for the DC circuit breaker 1 to verify the current breaking performance using the testing device including the current source circuit A and the voltage source circuit B, and the testing method includes supplying an AC current from at least the current source circuit A to the DC circuit breaker 1, breaking the current by the DC circuit breaker 1 at a time at which the current becomes equivalent to the fault current due to the system accident in the DC system, applying a voltage to the DC circuit breaker 1 by connecting the voltage source circuit B to the DC circuit breaker 1 before the current breaking, and applying the recovery voltage from the voltage source circuit B simultaneously with the current breaking.
   Hence, at the time of current breaking, the current equivalent to the fault current, and the voltage equivalent to the voltage at the time of the accident can be applied to the DC circuit breaker 1, an accident in the DC system where the DC circuit breaker 1 is provided can be simulated, and the current breaking performance of the DC circuit breaker 1 can be verified. In addition, if large-power testing equipment for general AC circuit breakers is present, the current breaking test for the DC circuit breaker 1 can be performed without installing a large-capacity DC power generator and a rectifier, which are expensive and large sized. In particular, in this embodiment, since the current breaking test for the DC circuit breaker 1 is performed using the conventional testing device applied in the synthetic testing method for AC circuit breakers, it is unnecessary to additionally prepare equipment investment and equipment layout site, etc., and financial advantage is large.
(2) The current source circuit A supplies an AC current less than the current equivalent to the fault current to the DC circuit breaker 1, and the voltage source circuit B is connected to the DC circuit breaker 1 before the current breaking by the DC circuit breaker 1, the current from the voltage source circuit B is superimposed on the current of the current source circuit A to obtain the current equivalent to the fault current, and the voltage is applied to the DC circuit breaker 1.

Hence, simultaneously with breaking of the current equivalent to the fault current, the recovery voltage can be applied to the DC circuit breaker 1 without a delay. That is, when the current breaking by the DC circuit breaker 1 is performed by a circuit breaker like a semiconductor breaker that can perform current breaking instantaneously, even if the connection of the voltage source circuit B to the DC circuit breaker 1 is attempted simultaneously with the current breaking, such connection is delayed from the time at which the current breaking is performed, and a time difference between the current breaking and the application of the recovery voltage may occur. According to this testing method, however, since the voltage source circuit B is connected before the current breaking and the voltage is applied, the time at which the current reaches the current equivalent to the fault current by the current breaking, and the time at which the voltage source circuit B applies the recovery voltage can be automatically matched. Hence, the recovery voltage can be applied simultaneously with the current breaking without a delay.

Furthermore, since the superimposed current is supplied from the voltage source circuit B, the current supplied by the current source circuit A can be reduced by what corresponds to the superimposed current. Hence, in comparison with the case in which the voltage source circuit B is connected to the DC circuit breaker 1 simultaneously with the current breaking, it becomes unnecessary to have the short-circuit generator 2 with a large current supply for the current source circuit A. Consequently, there are advantages such that variations in use of the testing device and circuit design can be increased.

(3) The voltage source circuit B includes the voltage source capacitor 10 serving as the voltage source, and the connection of the voltage source circuit B to the DC circuit breaker 1 is set to be a timing at which the current is broken and immediately before the current reaches the current equivalent to the fault current. Consequently, the predetermined recovery voltage can be surely applied at the time of current breaking. That is, when the voltage source is a capacitor, the energy is discharged along with the elapsed time of the connection of the voltage source circuit B, and the voltage decreases. Hence, when the voltage source circuit B is connected to the DC circuit breaker 1 at a stage quite earlier than the current breaking, there is a possibility that the predetermined recovery voltage for verifying the current breaking performance cannot be applied at the time of current breaking. Hence, in order to avoid this disadvantage, the connection timing is set to be immediately before the current reaches the fault current, and the predetermined recovery voltage can be further surely applied at the time of current breaking.

(4) In the application of the recovery voltage from the voltage source circuit B, the overvoltage is absorbed by the surge absorber 102 provided in parallel with the DC circuit breaker 1. Consequently, an application of the overvoltage to the breaker unit 101 of the DC circuit breaker 1 can be suppressed, and an application of the predetermined recovery voltage can be facilitated.

(5) The current breaking testing method for the DC circuit breaker 1 in this embodiment is a testing method for a DC circuit breaker to verify the current breaking performance using the testing device including the current source circuit A and the voltage source circuit B, and includes supplying, to the DC circuit breaker 1, a current equivalent to the fault current due to the system accident in the DC system from the current source circuit A, breaking the current by the DC circuit breaker 1, applying the recovery voltage from the current source circuit A to the DC circuit breaker 1, and applying the DC voltage from the voltage source circuit B to the DC circuit breaker 1 while the connection of the current source circuit A to the DC circuit breaker 1 is maintained and the recovery voltage is applied.

Consequently, since the application of the DC voltage from the voltage source circuit B is performed while the recovery voltage is applied, no voltage is applied from the voltage source circuit B to the DC circuit breaker 1 at least until the current breaking. Hence, the voltage of the voltage source circuit B can be maintained, and a condition, in which the recovery voltage becomes less than the voltage equivalent to the accident voltage of the DC system after the current breaking, disrupting the verification of the withstand voltage performance after the current breaking can be avoided. In other words, the recovery voltage of the breaker unit 101 of the DC circuit breaker 1 after the DC breaker 1 has completed the breaking of the fault current from the current source circuit A can be compensated, and the withstand voltage performance after the current breaking can be verified.

(5) In the application of the recovery voltage from the current source circuit A, the overvoltage is absorbed by the surge absorber 102 provided in parallel with the breaker unit 101 of the DC circuit breaker 1. Accordingly, an application of the overvoltage to the breaker unit 101 of the DC circuit breaker 1 is suppressed, facilitating an application of the predetermined recovery voltage.

### [2. Other Embodiments]

Several embodiments of the present disclosure have been described in this specification, but those embodiments are merely presented as examples, and are not intended to limit the scope of the present disclosure. The above embodiments can be carried out in other various forms, wherein the scope of the invention is defined by the claims.

As for other embodiments, the above testing method for the current breaking at the instant time and testing method after the current breaking can be achieved not by a worker, but by a control unit. That is, the control unit is a computer including a storage medium having stored therein a program to perform a sequence control, and may output connection or breaking instruction to the respective devices of each circuits A and B at a predetermined timing by executing the program.

In the first embodiment, the method of verifying the current breaking performance for the DC circuit breaker by the testing device to be applied to the synthetic testing method for AC circuit breakers has been described, but a testing device equivalent to the synthetic testing method may be applied.

The surge absorber 102 is provided in the DC circuit breaker 1, but may be provided outside the DC circuit breaker 1 as long as it is provided in parallel with the breaker unit 101.

### REFERENCE SIGNS LIST

1 DC circuit breaker
101 Breaker unit
102 Surge absorber
A Current source circuit
2 Short-circuit generator
3 Protection circuit breaker
4 Closing switch
5 Reactor
6 Resistor
7 Capacitor
8 Auxiliary circuit breaker
B Voltage source circuit
9 Charging device
10 Voltage source capacitor
11 Starting switch
12 Reactor
13 Resistor
14 Capacitor
15, 19 Current
16, 20 Surge absorber current
17, 21 Recovery voltage
18, 22 Voltage source capacitor voltage

## Claims

1. A testing method for a DC circuit breaker (1) to verify a current breaking performance using a testing device comprising a current source circuit (A) and a voltage source circuit (B), the method comprising:
supplying an AC current from at least the current source circuit (A) to the DC circuit breaker (1);
breaking the current by the DC circuit breaker (1) at a time the current becomes equivalent to a fault current due to a system accident in a DC system; and
applying a voltage to the DC circuit breaker (1), before the current breaking, by connecting the voltage source circuit (B) to the DC circuit breaker (1), and applying a predetermined recovery voltage from the voltage source circuit (B) simultaneously with the current breaking,
wherein:
the voltage source circuit (B) comprises a capacitor (10) serving as a voltage source; and
the connection of the voltage source circuit (B) to the DC circuit breaker (1) is set to be a timing immediately before the current breaking,
wherein the timing immediately before the current breaking means the timing at which the voltage source circuit (B) is capable of applying, to the DC circuit breaker (1), the predetermined recovery voltage, at a time of the current breaking,
**characterized in that**:
the current source circuit (A) supplies an AC current less than a current equivalent to the fault current to the DC circuit breaker (1); and
the voltage source circuit (B) is connected to the DC circuit breaker (1) before the current breaking by the DC circuit breaker (1) , to superimpose a current from the voltage source circuit (B) on the current of the current source circuit (A) to obtain the current equivalent to the fault current, and to apply a voltage to the DC circuit breaker (1).

2. The testing method for the DC circuit breaker (1) according to claim 1, wherein the testing device is a testing device applied for a synthetic testing method for AC circuit breakers.

3. The testing method for DC circuit breaker (1) according to any one of claims 1 to 2, wherein:
the DC circuit breaker (1) comprises a breaker unit (101) breaking a current; and
in the application of the recovery voltage from the voltage source circuit (B), an overvoltage is absorbed by a surge absorber provided in parallel with the breaker unit (101) of the DC circuit breaker (1).

## Patentansprüche

1. Prüfverfahren für einen Gleichstromschutzschalter (1) zum Überprüfen einer Stromabschaltungsleistung unter Verwendung einer Prüfvorrichtung, die eine Stromquellenschaltung (A) und eine Spannungsquellenschaltung (B) umfasst, wobei das Verfahren umfasst:
Versorgen des Gleichstromschutzschalters (1) mit einem Wechselstrom von mindestens der Stromquellenschaltung (A);
Abschalten des Stroms durch den Gleichstromschutzschalter (1) an einem Zeitpunkt, an dem der Strom aufgrund einer Systemstörung in einem Gleichstromsystem gleichwertig mit einem Fehlerstrom wird; und
vor dem Stromabschalten, Anlegen einer Spannung an den Gleichstromschutzschalter (1) durch Verbinden der Spannungsquellenschaltung (B) mit dem Gleichstromschutzschalter (1) und Anlegen einer vorbestimmten wiederkehrenden Spannung von der Spannungsquellenschaltung (B) gleichzeitig mit dem Stromabschalten,
wobei:
die Spannungsquellenschaltung (B) einen Kondensator (10) umfasst, der als eine Spannungsquelle dient; und
die Verbindung der Spannungsquellenschaltung (B) mit dem Gleichstromschutzschalter (1) eingestellt wird, um ein Zeitpunkt unmittelbar vor dem Stromabschalten zu sein,
wobei mit dem Zeitpunkt unmittelbar vor dem Stromabschalten der Zeitpunkt gemeint ist, an dem die Spannungsquellenschaltung (B) in der Lage ist, die vorbestimmte wiederkehrende Spannung an einem Zeitpunkt des Stromabschaltens an den Gleichstromschutzschalter (1) anzulegen,
**dadurch gekennzeichnet, dass**:
die Stromquellenschaltung (A) den Gleichstromschutzschalter (1) mit einem Wechselstrom versorgt, der niedriger als ein Strom ist, der gleichwertig mit dem Fehlerstrom ist; und
die Spannungsquellenschaltung (B) vor dem Stromabschalten durch den Gleichstromschutzschalter (1) mit dem Gleichstromschutzschalter (1) verbunden ist, um einen Strom von der Spanungsquellenschaltung (B) auf dem Strom der Stromquellenschaltung (A) zu überlagern, um den Strom zu erhalten, der gleichwertig mit dem Fehlerstrom ist, und eine Spannung an den Gleichstromschutzschalter (1) anzulegen.

2. Prüfverfahren für den Gleichstromschutzschalter (1) nach Anspruch 1, wobei die Prüfvorrichtung eine Prüfvorrichtung ist, die für ein synthetisches Prüfverfahren für Wechselstromschutzschalter angewandt wird.

3. Prüfverfahren für einen Gleichstromschutzschalter (1) nach einem der Ansprüche 1 bis 2, wobei:
der Gleichstromschutzschalter (1) eine Abschaltereinheit (101) umfasst, die einen Strom abschaltet; und
beim Anlegen der wiederkehrenden Spannung von der Spannungsquellenschaltung (B) eine Überspannung durch einen Wellenschlucker absorbiert wird, der parallel mit der Abschaltereinheit (101) des Gleichstromschutzschalters (1) bereitgestellt ist.

## Revendications

1. Procédé d'essai destiné à un disjoncteur à courant continu (1) pour vérifier une performance de coupure de courant en utilisant un dispositif d'essai comprenant un circuit de source de courant (A) et un circuit de source de tension (B), le procédé comprenant :
la fourniture d'un courant alternatif à partir d'au moins le circuit de source de courant (A) au disjoncteur à courant continu (1) ;
la coupure du courant par le disjoncteur à courant continu (1) au moment où le courant devient équivalent à un courant de défaut en raison d'un accident de système dans un système à courant continu ; et
l'application d'une tension au disjoncteur à courant continu (1), avant la coupure de courant, par le raccordement du circuit de source de tension (B) au disjoncteur à courant continu (1), et l'application d'une tension de récupération prédéterminée à partir du circuit de source de tension (B) simultanément avec la coupure de courant,
dans lequel :
le circuit de source de tension (B) comprend un condensateur (10) servant de source de tension ; et
le raccordement du circuit de source de tension (B) au disjoncteur à courant continu (1) est réglé pour intervenir à un moment immédiatement avant la coupure de courant,
dans lequel le moment immédiatement avant la coupure de courant signifie le moment auquel le circuit de source de tension (B) est capable d'appliquer, au disjoncteur à courant continu (1), la tension de récupération prédéterminée, au stade de la coupure de courant,
**caractérisé en ce que** :
le circuit de source de courant (A) fournit un courant alternatif inférieur à un courant équivalent au courant de défaut au disjoncteur à courant continu (1) ; et
le circuit de source de tension (B) est raccordé au disjoncteur à courant continu (1) avant la coupure de courant par le disjoncteur à courant continu (1), pour superposer un courant à partir du circuit de source de tension (B) sur le courant du circuit de source de courant (A) afin d'obtenir le courant équivalent au courant de défaut, et pour appliquer une tension au disjoncteur à courant continu (1).

2. Procédé d'essai destiné au disjoncteur à courant continu (1) selon la revendication 1, dans lequel le dispositif d'essai est un dispositif d'essai appliqué à un procédé d'essai synthétique pour des disjoncteurs à courant alternatif.

3. Procédé d'essai destiné au disjoncteur à courant continu (1) selon la revendication 1 ou 2, dans lequel :
le disjoncteur à courant continu (1) comprend une unité de coupure (101) coupant un courant ; et
dans l'application de la tension de récupération à partir du circuit de source de tension (B), une surtension est amortie par un amortisseur de surtension prévu en parallèle à l'unité de coupure (101) du disjoncteur à courant continu (1).
